# EUROPEAN PATENT APPLICATION

(11) **EP 1 557 855 A2**
(43) Date of publication of application: **27.07.2005**
(21) Application number: 05000757.4
(22) Date of filing: 14.01.2005
(51) Int. Cl.: H01J 9/18, H01J 9/24, H01J 17/49, B32B 27/18, C08K 3/40, B32B 7/12, B32B 31/08, B32B 33/00

(54) **Laminate sheet, method of producing back substrate for plasma display panel, back substrate for plasma display panel, and plasma display panel**

(30) Priority: 15.01.2004 JP 2004008137; 01.07.2004 JP 2004195612
(71) Applicant: Nitto Denko Corporation, Ibaraki-shi, Osaka 567-8680 (JP)
(72) Inventor: Banba, Tomohide, Ibaraki-shi Osaka 567-8680 (JP); Kume, Katsuya, Ibaraki-shi Osaka 567-8680 (JP); Kai, Makoto, Ibaraki-shi Osaka 567-8680 (JP); Ando, Masahiko, Ibaraki-shi Osaka 567-8680 (JP); Buzoujima, Yasushi, Ibaraki-shi Osaka 567-8680 (JP); Hatanaka, Itsuhiro, Ibaraki-shi Osaka 567-8680 (JP)
(74) Representative: VOSSIUS & PARTNER

(57) **Abstract**

The invention provides a laminate sheet used for forming a dielectric layer and a rib simultaneously and integrally. The invention also provides a method of producing a back substrate for plasma display panel, which is excellent in the efficiency of production by reducing the production process significantly by using the laminate sheet. The laminate sheet of the invention is used for integrally forming a dielectric layer and a rib on a glass substrate having electrodes, which comprises a barrier layer laminated on a glass resin composition layer containing inorganic powder and a binder resin, and an inorganic powder-containing viscoelastic layer laminated on the barrier layer.

## Description

The present invention relates to a laminate sheet used for integrally forming a dielectric layer and a rib, a method of producing a back substrate for plasma display panel by using the laminate sheet, a back substrate for plasma display panel, and a plasma display panel.

As thin and flat large displays, plasma display panels (referred to hereinafter as "PDP") together with liquid crystal displays attract attention in recent years.

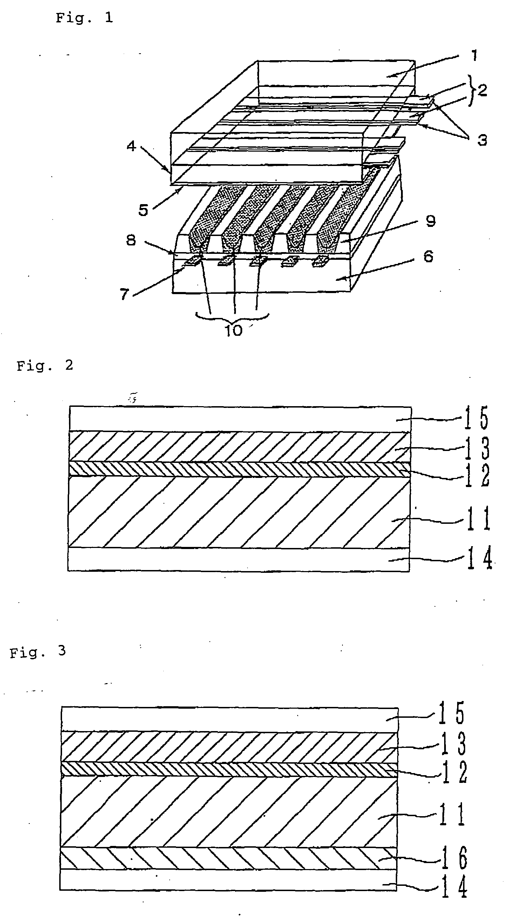

Fig. 1 shows one example of PDP of 3-electrode-surface-discharge type. In Fig. 1, a sustained electrode (display electrode) 2 consisting of a transparent electroconductive film is formed on a front glass substrate 1 serving as a display surface, and a bus electrode 3 consisting of a metallic film of small width compensating for electrical conductivity is formed on the sustained electrode 2. Further, a dielectric layer 4 is formed so as to cover the sustained electrode 2 and the bus electrode 3, and MgO film (protective layer) 5 is formed so as to cover the dielectric layer 4.

On one hand, an address electrode (data electrode) 7 consisting of a metallic film is formed on a back glass substrate 6, and a dielectric layer 8 is formed on the address electrode 7. A rib 9 for maintaining a predetermined distance between the front glass substrate 1 and the back glass substrate 6 to maintain a discharge space therebetween is formed between the address electrodes 7. Fluorescent layers 10 of 3 primary colors (red, green and blue) are formed to cover the dielectric layer 8 and rib 9. A rare gas is encapsulated in the discharge space, and each intersection of the address electrode 7 and sustained electrode 2 constitutes a pixel cell.

As a method of forming the dielectric layer 8, mention is made of a method which involves directly applying a paste composition containing glass powder, a binder resin and a solvent onto the surface of a glass substrate having electrodes fixed thereon to form a film-forming material layer and then baking the film-forming material layer thereby forming a dielectric layer on the surface of the glass substrate. Further, a method of forming a dielectric layer on the surface of a glass substrate, which comprises applying a paste composition containing glass powder, an acrylate resin and a solvent onto a support film to form a film-forming material layer, transferring the film-forming material layer formed on the support film to the surface of a glass substrate having electrodes fixed thereon, and baking the transferred film-forming material layer to form a dielectric layer on the surface of the glass substrate (JP-A 9-102273, JP-A 11-35780, JP-A 2001-185024, and International Publication No. 00/42622).

The rib 9 maintaining a discharge space is required to be a rib of large height to form the largest discharge space to achieve emission of light with high brightness, and usually a height of about 100 to 300 µm is necessary. Conventionally, the rib 9 has been formed by repeatedly applying a glass paste ten or more times onto the dielectric layer 8 by screen printing using a rib pattern-forming printing plate and subsequent drying thereof to form a glass resin composition layer, and then baking the glass resin composition layer. When the thickness of a coating formed by performing screen printing once is increased, a region around the coating is sagged to undergo shaping insufficiency, and thus the thickness of the coating formed by performing screen printing once is about 10 to 30 µm. In the method of forming the rib, therefore, screen printing of the glass paste and subsequent drying should be carried out repeatedly, and there are problems such as poor accuracy of formation of the rib and low productivity.

As the method of solving the problem described above, a method of forming a rib is disclosed wherein a dry glass paste film having a thickness of 100 to 300 µm in a green state and a dry photoresist film are laminated on a glass substrate, and via a rib-patterning mask, the dry photoresist film is exposed to light and developed, and thereafter, the light-exposed and developed dry photoresist film is used as a mask to sandblast the dry glass paste film to form concaves for forming discharge spaces, the dry photoresist film is removed, and the dry glass paste film is baked thereby forming a rib (JP-A 8-222135).

Another method of forming a rib is disclosed wherein a rib-forming layer is transferred from a transfer sheet having the rib-forming layer formed on a base film to a glass substrate, a resist pattern is formed on the top of the transferred rib-forming layer, the rib-forming material in openings of the resist pattern is removed by sandblasting, then the resist remaining on the rib-forming material is removed, and the rib-forming material is calcined by baking to form a rib (JP-A 8-273536).

Further, a method of forming a rib, which comprises sticking an adhesive sheet for rib onto a back glass substrate, baking it preliminarily at 150 to 350°C, sandblasting it to form a rib, and baking it at 400 to 750°C, is also disclosed (JP-A 11-185603).

A transfer sheet capable of forming a highly accurate thick pattern for a rib, which comprises a base film, a transfer layer arranged in a releasable manner on the base film, and a stress-absorbing layer arranged on the transfer layer, is also disclosed (JP-A 11-260250).

A method of producing a back substrate for plasma display panel, which comprises forming a crystalline glass-containing metal paste on a substrate, so as to correspond to a pattern of address electrodes, forming a low-melting glass paste on substantially the whole area of the substrate including the metal paste, forming a rib material layer of low-melting glass on a predetermined position of the low-melting glass paste, and then baking the metal paste, the low-melting glass paste and the low-melting glass rib material layer simultaneously thereby forming a laminate of address electrodes, a dielectric layer and a rib on the substrate, is also disclosed (JP-A 2003-223851).

Further, there is also disclosed a method of forming a plasma display panel, which comprises a first step of forming a dielectric layer-forming layer on a substrate, a second step of forming a rib-forming layer on the dielectric layer-forming layer, a third step of forming a resist pattern on the rib-forming layer, a fourth step of removing the rib-forming layer in openings of the resist pattern by sandblasting, a fifth step of removing the resist pattern on the rib-forming layer and a sixth step of calcining the dielectric layer-forming layer and the rib-forming layer simultaneously by baking (JP-A 10-144206).

However, the method of forming a rib as described in JP-A 8-222135, JP-A 8-273536 and JP-A 11-185603 is a method which involves firstly forming a dielectric layer on a back glass substrate having electrodes fixed thereon and then forming a rib on the dielectric layer, and thus the two steps, that is, the step of forming a dielectric layer and the step of forming a rib are essential. By the above method of forming a rib, productivity may be improved to a certain degree, but the two steps (the step of forming a dielectric layer and the step of forming a rib) are essential as is the case with the prior art, and thus sufficient improvement in productivity cannot be expected. The transfer sheet described in JP-A 11-260250 is used in independently forming an electrode pattern, a dielectric layer and a rib, and is not used in forming a dielectric layer and a rib simultaneously and integrally.

The method of producing a back substrate for PDP described in JP-A 2003-223851 can form a laminate of address electrodes, a dielectric layer and a rib on a substrate by baking a metal paste, a low-melting glass paste and a low-melting glass rib material layer simultaneously, and thus improvement in productivity to a certain extent can be expected. However, the step of coating and drying the low-melting glass paste after formation of the electrode pattern and the step of forming the low-melting glass rib material on the low-melting glass paste are necessary, and thus a significant reduction in the production process does not result.

The method of producing a plasma display panel as described in JP-A 10-144206 can form a dielectric layer and a rib layer simultaneously on a substrate by baking a dielectric layer-forming layer and a rib-forming layer simultaneously, and thus improvement in productivity to a certain extent can be expected. However, the first step of forming a dielectric layer-forming layer on a substrate and the second step of forming a rib-forming layer on the dielectric layer-forming layer are necessary, and thus a significant reduction in the production process does not result. Further, when a transfer sheet for forming the rib-forming layer is used, a plasticizer is added to the material forming the rib layer-forming layer in order to improve the transferability of the sheet, and thus a step of removing the plasticizer by heating after transfer is necessary for improving operativeness in sandblasting, for preventing the influence of the bleed plasticizer on a resist pattern and for improving the shape of the rib-forming layer, and therefore the production process is troublesome.

To solve the problems in the prior art described above, an object of the present invention is to provide a laminate sheet used in forming a dielectric layer and a rib simultaneously and integrally. Another object of the invention is to provide a method of producing a back substrate for plasma display panel, which is excellent in production efficiency by significantly reducing the production process by using the laminate sheet. A still other object of the invention is to provide a back substrate for plasma display panel produced by the method described above and a plasma display panel using the back substrate.

As a result of extensive study for solving the problem, the present invention found that the laminate sheet shown below can achieve the object, and the present invention was thereby completed.

That is, the present invention relates to a laminate sheet used for integrally forming a dielectric layer and a rib on a glass substrate having electrodes, which comprises a barrier layer laminated on a glass resin composition layer containing inorganic powder and a binder resin, an inorganic powder-containing viscoelastic layer laminated on the barrier layer. In the laminate sheet, it is preferable that a base film is laminated on the other side of the glass resin composition layer. It is also preferable in the laminate sheet that a photoresist layer is laminated between the glass resin composition layer and the base film.

The method of producing a back substrate for PDP according to the present invention comprises a step of attaching a viscoelastic layer of the laminate sheet of claim 1 onto a glass substrate having electrodes, a step of forming a resist pattern on the surface of the glass resin composition layer, a step of sandblasting the glass resin composition layer in openings of the resist pattern thereby integrally forming a rib-forming part and a dielectric layer-forming film covering electrodes, and a step of baking the rib-forming part, the dielectric layer-forming film, the barrier layer and the viscoelastic layer thereby forming the rib and the dielectric layer integrally.

Another method of producing a back substrate for PDP according to the present invention comprises a step of forming an electrode pattern consisting of a metal paste on a glass substrate, a step of attaching a viscoelastic layer of the laminate sheet of claim 1 onto the glass substrate having an electrode pattern, a step of forming a resist pattern on the surface of the glass resin composition layer, a step of sandblasting the glass resin composition layer in openings of the resist pattern thereby integrally forming a rib-forming part and a dielectric layer-forming film covering an electrode pattern, and a step of baking the electrode pattern, the rib-forming part, the dielectric layer-forming film, the barrier layer and the viscoelastic layer thereby forming electrodes and forming the rib and the dielectric layer integrally.

Another method of producing a back substrate for PDP according to the present invention comprises a step of attaching a viscoelastic layer of the laminate sheet of claim 2 onto a glass substrate having electrodes, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering electrodes, and a step of baking the rib-forming part, the dielectric layer-forming film, the barrier layer and the viscoelastic layer thereby forming the rib and the dielectric layer integrally.

Another method of producing a back substrate for PDP according to the present invention comprises a step of forming an electrode pattern consisting of a metal paste on a glass substrate, a step of attaching a viscoelastic layer of the laminate sheet of claim 2 onto the glass substrate having an electrode pattern, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering an electrode pattern, and a step of baking the electrode pattern, the rib-forming part, the dielectric layer-forming film, the barrier layer and the viscoelastic layer thereby forming electrodes and forming the rib and the dielectric layer integrally.

In the production method described above, it is preferable that the pattern-forming step is a step of forming a resist pattern by laminating a photoresist layer and a pattern-forming mask on the glass resin composition layer and light-exposing and developing the photoresist layer via the pattern-forming mask.

Another method of producing a back substrate for PDP according to the present invention comprises a step of attaching a viscoelastic layer of the laminate sheet of claim 3 onto a glass substrate having electrodes, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering electrodes, and a step of baking the rib-forming part, the dielectric layer-forming film, the barrier layer and the viscoelastic layer thereby forming the rib and the dielectric layer integrally.

Another method of producing a back substrate for PDP according to the present invention comprises a step of forming an electrode pattern consisting of a metal paste on a glass substrate, a step of attaching a viscoelastic layer of the laminate sheet of claim 3 onto the glass substrate having an electrode pattern, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering an electrode pattern, and a step of baking the electrode pattern, the rib-forming part, the dielectric layer-forming film, the barrier layer and the viscoelastic layer thereby forming electrodes and forming the rib and the dielectric layer integrally.

In the production method described above, it is preferable that the pattern-forming step is a step of forming a resist pattern by laminating a pattern-forming mask on a photoresist layer and light-exposing and developing the photoresist layer via the pattern-forming mask.

Preferably, the method of producing a back substrate for PDP according to the present invention comprises a step of removing the resist pattern on the glass resin composition layer between the sandblasting step and the baking step.

The present invention also relates to a back substrate for PDP, which is produced by the method described above.

Further, the present invention relates to a PDP using the back substrate for PDP described above.

Hereinafter, the present invention is described in more detail.
Fig. 1 is a perspective view showing the structure of a PDP of 3-electrode-surface-discharge type.
Fig. 2 is a sectional view showing one example of the laminate sheet of the present invention.
Fig. 3 is a sectional view showing another example of the laminate sheet of the present invention.
Fig. 4 is a flow sheet showing one example of the method of producing a back substrate for PDP according to the present invention.
Fig. 5 is a microphotograph (SEM photograph, ×200) of a section of a glass substrate having a rib-forming part and a dielectric layer-forming film formed integrally thereon before a baking step.
Fig. 6 is a microphotograph (SEM photograph, ×200) of a section of a glass substrate having a rib and a dielectric layer formed integrally thereon after a baking step.

As shown in Fig. 2, the laminate sheet of the present invention comprises a barrier layer 12 and an inorganic powder-containing viscoelastic layer 13 laminated in this order on a glass resin composition layer 11 containing inorganic powder and a binder resin, and is used to form a dielectric layer and a rib formed integrally on a glass substrate having electrodes. The laminate sheet of the present invention preferably has a base film 14 on the other side of the glass resin composition layer 11. The base film 14 is used preferably in facilitating formation of the glass resin composition layer 11, and in transferring the laminate sheet to the surface of a glass substrate having electrodes or an electrode pattern (which will form electrodes by baking). The laminate sheet of the present invention preferably has a protective film 15 on the surface of the viscoelastic layer 13. By arranging the protective film 15, the laminate sheet can be stored and supplied in a rolled state.

As shown in Fig. 3, the laminate sheet of the present invention may have a photoresist layer 16 laminated between the glass resin composition layer 11 and base film 14. The photoresist layer 16 can be arranged on one side of the glass resin composition layer 11 in order to simplify the step of forming a resist pattern on the surface of the glass resin composition layer 11. The glass resin composition layer 11 contains at least inorganic powder and a binder resin.

As the inorganic powder, known one can be used without particular limitation, and specific examples include silicon oxide, titanium oxide, aluminum oxide, calcium oxide, boron oxide, zinc oxide and glass powder. The average particle diameter of the inorganic powder is preferably 0.1 to 30 µm.

In the present invention, glass frit is preferably used as inorganic powder. As the glass frit, known one can be used without particular limitation. Examples of the glass frit include 1) a mixture of zinc oxide, boron oxide and silicon oxide (ZnO-B₂O₃-SiO₂ system), 2) a mixture of zinc oxide, boron oxide, silicon oxide and aluminum oxide (ZnO-B₂O₃-SiO₂-Al₂O₃ system), 3) a mixture of lead oxide, boron oxide, silicon oxide and calcium oxide (PbO-B₂O₃-SiO₂-CaO system), 4) a mixture of lead oxide, boron oxide, silicon oxide and aluminum oxide (PbO-B₂O₃-SiO₂-Al₂O₃ system), 5) a mixture of lead oxide, zinc oxide, boron oxide and silicon oxide (PbO-ZnO-B₂O₃-SiO₂ system), and 6) a mixture of lead oxide, zinc oxide, boron oxide, silicon oxide and aluminum oxide (PbO-ZnO-B₂O₃-SiO₂-Al₂O₃ system). If necessary, these inorganic powders may contain Na₂O, CaO, BaO, Bi₂O₃, SrO, TiO₂, CuO or In₂O₃. The glass frit used is preferably low-melting frit hardly undergoing warpage attributable to a difference in thermal expansion coefficient from the glass substrate upon baking and capable of baking at temperatures at which the glass substrate is not deformed. In consideration of integral formation of the dielectric layer and the rib by baking treatment, glass frit having a softening point of 400 to 650°C is preferable.

As the binder resin, known one can be used without particular limitation, but the binder resin is preferably the one excellent in an ability to disperse inorganic powder, capable of improving the ability of the glass resin composition layer to be condensed, and completely removable by pyrolysis in a baking step. Specifically, (meth)acrylic resin, vinyl resin, cellulose resin etc. can be mentioned.

The (meth)acrylic resin is a polymer of one kind of acrylic or methacrylic monomer, a copolymer of the monomers, or a mixture thereof. Examples of the (meth)acrylic monomer include alkyl (meth)acrylates such as methyl (meth)acrylate, ethyl (meth)acrylate, propyl (meth)acrylate, t-butyl (meth)acrylate, pentyl (meth)acrylate, amyl (meth)acrylate, isoamyl (meth)acrylate, hexyl (meth)acrylate, heptyl (meth)acrylate, octyl (meth)acrylate, isooctyl (meth)acrylate, ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate and isostearyl (meth)acrylate, and aryl (meth)acrylates such as phenyl (meth)acrylate and tolyl (meth)acrylate.

A (meth)acrylic monomer having a polar group such as hydroxyl group and carboxyl group may also be used. Examples of the (meth)acrylic monomer having a polar group include (meth)acrylic acid, itaconic acid, (meth)acrylamide, N-methylol (meth)acrylamide, 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, polyethylene glycol mono(meth)acrylate, 2-(meth)acryloyloxyethylsuccinic acid, 2-(meth)acryloyloxyethylphthalic acid, iminol(meth)acrylate etc.

The vinyl resin includes polyvinyl acetals such as polyvinyl formal, polyvinyl butyral etc., and polyvinyl alkyl ethers such as polyvinyl alcohol, polyvinyl acetate, polyvinyl methyl ether etc.

The cellulose resin includes cellulose esters such as acetate cellulose and butyrate cellulose, methyl cellulose, ethyl cellulose, hydroxy ethyl cellulose, carboxymethyl cellulose etc.

The binder resin is added in an amount of preferably 10 parts by weight or less, more preferably 8 parts by weight or less, still more preferably 5 parts by weight or less, relative to 100 parts by weight of the inorganic powder. When the amount of the binder resin added is higher than 10 parts by weight, the hardness of the glass resin composition layer is reduced so that the glass resin composition layer is hardly cut in sand blast treatment, and accordingly the efficiency of sand blast treatment may be deteriorated, and a highly accurate rib may be hardly formed. The binder resin is added in an amount of 0.3 parts by weight or more, more preferably 0.5 parts by weight or more, still more preferably 0.7 parts by weight or more, relative to 100 parts by weight of the inorganic powder. When the amount of the binder resin added is lower than 0.3 parts by weight, the glass paste composition may be hardly formed into a sheet.

When the composition containing inorganic powder and a binder resin is applied onto a base film (support film) to prepare a transfer sheet having a glass resin composition layer formed thereon, a solvent is preferably added to the composition so as to apply it uniformly onto the base film.

The solvent is particularly not limited insofar as it is compatible with inorganic powder and excellent in an ability to solubilize the binder resin. Examples of the solvent include terpineol, dihydro-α-terpineol, dihydro-α-terpinyl acetate, butyl carbitol acetate, butyl carbitol, isopropyl alcohol, benzyl alcohol, turpentine oil, diethyl ketone, methyl butyl ketone, dipropyl ketone, cyclohexanone, n-pentanol, 4-methyl-3-pentanol, cyclohexanol, diacetone alcohol, ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, n-butyl acetate, amyl acetate, methyl cellosolve acetate, ethyl cellosolve acetate, propylene glycol monomethyl ether acetate, ethyl-3-ethoxy propionate, 2,2,4-trimethyl-1,3-pentanediol-1-isobutyrate, and 2,2,4-trimethyl-1,3-pentanediol-3-isobutyrate. These solvents may be used singly or as a mixture of two or more thereof in an arbitrary ratio.

The amount of the solvent to be added is preferably 10 to 100 parts by weight relative to 100 parts by weight of the inorganic powder.

A plasticizer may be added to the glass resin composition layer. The plasticizer can be added to regulate the pliability and flexibility of a transfer sheet consisting of a glass resin composition layer formed by applying the composition containing inorganic powder and a binder resin onto a base film, the transferability of the glass resin composition layer to a glass substrate, etc.

As the plasticizer, known one can be used without particular limitation. Examples thereof include plasticizers such as adipic acid derivatives such as diisononyl adipate, di-2-ethylhexyl adipate, dibutyl diglycol adipate etc., azelaic acid derivatives such as di-2-ethylhexyl azelate, sebacic acid derivatives such as di-2-ethylhexyl sebacate, trimellitic acid derivatives such as tri(2-ethylhexyl) trimellitate, trioctyl trimellitate, triisononyl trimellitate, triisodecyl trimellitate etc., pyromellitic acid derivatives such as tetra-(2-ethylhexyl) pyromellitate etc,. oleic acid derivatives such as propylene glycol monooleate etc., and glycols such as polyethylene glycol, polypropylene glycol etc.

The amount of the plasticizer added is preferably 5 parts by weight or less, more preferably 3 parts by weight or less, still more preferably 1 part by weight or less, relative to 100 parts by weight of the inorganic powder. It is not preferable that the amount of the plasticizer added is higher than 5 parts by weight because the strength and hardness of the resulting glass resin composition layer are deteriorated, and thus the glass resin composition layer is hardly cut in sand blast treatment. In addition to the components described above, various kinds of additives such as a dispersant, a silane coupling agent, a tackifier, a leveling agent, a stabilizer and a defoaming agent may be added to the glass resin composition layer. Further, a black or white pigment may be added to reduce the light reflection of a rib formed and to improve contrast.

The barrier layer 12 is a layer having the function of conferring flexibility on the laminate sheet to improve the transferability of the laminate sheet, the function of forming a thin dielectric layer-forming film on the barrier layer 12 by sandblasting the glass resin composition layer 11, and the function of preventing the viscoelastic layer 13 from being cut by sand blast treatment.

The material forming the barrier layer is not particularly limited, and it is possible to employ, for example, various kinds of pressure-sensitive adhesive compositions (pressure-sensitive adhesives) such as an acrylic pressure-sensitive adhesive, a synthetic rubber-based pressure-sensitive adhesive, a natural rubber-based pressure-sensitive adhesive, a silicone-based pressure-sensitive adhesive, and heat-sensitive adhesives not showing adhesion at ordinary temperature, but showing adhesion by heating.

The acrylic pressure-sensitive adhesive comprises an acrylic polymer as a base polymer, and the monomer used in the acrylic polymer includes various alkyl (meth)acrylates. Examples thereof include alkyl (meth)acrylates (for example, C1 to C20 alkyl esters such as methyl ester, ethyl ester, propyl ester, butyl ester, 2-ethylhexyl ester, isooctyl ester, isononyl ester, isodecyl ester, dodecyl ester, lauryl ester, tridecyl ester, pentadecyl ester, hexadecyl ester, heptadecyl ester, octadecyl ester, nonadecyl ester, eicosyl ester etc.), and these can be used alone or as a mixture thereof.

Together with the alkyl (meth)acrylates, carboxyl group-containing monomers such as (meth)acrylic acid, itaconic acid etc.; hydroxyl group-containing monomers such as hydroxyethyl (meth)acrylate, hydroxypropyl (meth)acrylate etc.; amide group-containing monomers such as N-methylol acrylamide etc.; cyano group-containing monomers such as (meth)acrylonitrile etc.; epoxy group-containing monomers such as glycidyl (meth)acrylate etc.; vinyl esters such as vinyl acetate etc.; and styrene monomers such as styrene, α-methyl styrene etc. can be used as copolymerizable monomers. The method of polymerizing the acrylic polymer is not particularly limited, and known polymerization methods such as solution polymerization, emulsion polymerization, suspension polymerization, UV polymerization etc. can be used.

The base polymer in the rubber-based pressure-sensitive adhesive includes, for example, natural rubber, isoprene rubber, styrene-butadiene rubber, regenerated rubber, polyisobutylene rubber, styrene-isoprene-styrene rubber, styrene-butadiene-styrene rubber etc.

The base polymer in the silicone-based pressure-sensitive adhesive includes, for example, dimethyl polysiloxane, diphenyl polysiloxane etc.

The base polymer in the heat-sensitive adhesive includes, for example, cellulose resin, ethylene-vinyl acetate copolymer, polyvinyl alcohol, butyral resin, polyester resin, polyethylene resin, polypropylene resin, butadiene-styrene copolymer etc.

A crosslinking agent can be added to the pressure-sensitive adhesive. The crosslinking agent includes a polyisocyanate compound, a polyamine compound, melamine resin, urea resin, epoxy resin etc. In the pressure-sensitive adhesive, a tackifier, a plasticizer, a filler, an antioxidant, a UV absorber and a silane coupling agent can also be suitably used if necessary.

The barrier layer may also contain a small amount of inorganic powder used in the glass resin composition layer or the viscoelastic layer. When the barrier layer is made exclusively of the pressure-sensitive adhesive, the thermal shrinkage coefficient of the barrier layer upon baking tends to be higher than the thermal shrinkage coefficient of the layers on both sides, and due to this difference in thermal shrinkage coefficient, the glass resin composition layer and the viscoelastic layer are released in a few cases upon high-speed baking, the rib or the dielectric layer after baking may be cracked. In this case, a small amount of inorganic powder is added to the barrier layer, to reduce a difference in thermal shrinkage coefficient between the barrier layer and the layers on both sides, whereby the adhesion between the glass resin composition layer and the viscoelastic layer upon high-speed baking can be increased, and interlaminar release etc. can be prevented. By preventing interlaminar release and cracking, the rate of heating can be increased to improve productivity while qualities are maintained.

The amount of the inorganic powder added to the barrier layer is preferably 1 to 100 parts by weight, more preferably 2 to 50 parts by weight, still more preferably 3 to 30 parts by weight, relative to 100 parts by weight of the base polymer. When the amount of the inorganic powder is less than 1 part by weight, the adhesion between the glass resin composition layer and the viscoelastic layer upon baking at high speed may not be sufficiently achieved. On one hand, when the amount of the inorganic powder is 100 parts by weight or more, a dielectric layer-forming film may not be formed, and the barrier layer may be cut by sand blasting, to make it difficult to protect the viscoelastic layer against sand blasting.

The viscoelastic layer 13 is a layer having the function of conferring flexibility on the laminate sheet to improve the transferability of the laminate sheet, the function of maintaining the glass resin composition layer 11 on a glass substrate having electrodes or an electrode pattern, the function of covering the electrode or electrode pattern, and the function of reliably covering the electrode after converting the inorganic powder-containing viscoelastic layer by baking into a dielectric layer.

The viscoelastic layer contains at least inorganic powder and a viscoelastic resin component. As the inorganic powder, the known one which can protect an electrode and exhibit desired performance as dielectric layer can be used without particular limitation, and specifically, inorganic powder used in the glass resin composition layer can be mentioned. The inorganic powder used in the viscoelastic layer and the inorganic powder used in the glass resin composition layer preferably have the same composition so that the adhesion (affinity) between a dielectric layer obtained by baking the viscoelastic layer and a rib and a dielectric layer obtained by baking a rib-forming part and a dielectric layer-forming film respectively can be improved, and the baking temperature can be in a similar degree to facilitate the baking step.

The viscoelastic resin component is not particularly limited insofar as it can disperse and maintain inorganic powder uniformly and can confer sufficient viscoelasticity on the viscoelastic layer containing the inorganic powder. As the viscoelastic resin component, various kinds of pressure-sensitive compositions (pressure-sensitive adhesive) such as an acrylic pressure-sensitive adhesive, a synthetic rubber pressure-sensitive adhesive, a natural rubber pressure-sensitive adhesive and a silicone-based pressure-sensitive adhesive used in the barrier layer, heat-sensitive adhesives not showing adhesion at ordinary temperature, but showing adhesion upon heating, or (meth)acrylic resin used as a binder for inorganic powder, can be used.

The viscoelastic resin component is added in an amount of preferably 3 to 100 parts by weight, more preferably 5 to 80 parts by weight, still more preferably 10 to 60 parts by weight, relative to 100 parts by weight of the inorganic powder. When the amount of the viscoelastic resin component added is less than 3 parts by weight, the inorganic powder cannot be uniformly dispersed, and thus the viscoelastic layer is hardly formed into a sheet, and the flexibility of the viscoelastic layer tends to be insufficient to deteriorate the transferability of the laminate sheet.

On the other hand, when the amount of the viscoelastic resin component added is higher than 100 parts by weight, the organic components may remain on the glass substrate after baking to deteriorate the qualities of the back substrate for PDP. Further, the strength of the viscoelastic layer is lowered so that when the laminate sheet is attached to a glass substrate, the attachment position may be easily deviated from the right position. Further, the viscoelasticity of the viscoelastic layer may be made significant to deteriorate the efficiency of cutting of the glass resin composition layer.

A crosslinking agent can also be added to the viscoelastic resin component. The crosslinking agent includes a polyisocyanate compound, a polyamine compound, melamine resin, urea resin, epoxy resin etc. In the pressure-sensitive adhesive, a tackifier, a plasticizer, a filler, an antioxidant, a UV absorber, a silane coupling agent etc. can be suitably used if necessary.

The method of producing a laminate sheet according to the present invention is not particularly limited, and for example, a composition containing inorganic powder and a binder resin is applied onto a base film 14, and the solvent is dried and removed, to form a glass resin composition layer 11. Thereafter, a barrier layer-forming composition is directly applied onto the glass resin composition layer 11, and the solvent if any is dried, to form a barrier layer, and a viscoelastic layer-forming composition is applied onto the formed barrier layer, and the solvent if any is dried, to form a viscoelastic layer, whereby a laminate sheet can be produced (direct coating method). Alternatively, a viscoelastic layer 13 and barrier layer 12 are formed in this order on a protective film 15 or a release liner in the same manner as described above to produce a laminate, and the laminate may be transferred to the glass resin composition layer 11 to produce a laminate sheet (transfer method).

Alternatively, the glass resin composition layer 11 is formed on the release liner, and then the release liner is released. The viscoelastic layer 13 and barrier layer 12 are formed in this order on the protective film 15 to produce a laminate, and the barrier layer 12 of the laminate is attached to that side of the glass resin composition layer 11 from which the release liner was released. Then, the base film 14 is attached to the other side of the glass resin composition layer 11 to produce a laminate sheet. This production method is effective where a dry film resist is attached to the surface of the glass resin composition layer 11 to form a photoresist layer.

The base film 14 is preferably a resin film having heat resistance, solvent resistance and pliability. When the base film is pliable, a paste composition that is a material forming the glass resin composition layer can be applied by a roll coater or the like, and the resulting laminate sheet can be stored and supplied in a rolled state.

The resin forming the base film 14 includes, for example, polyethylene terephthalate, polyester, polyethylene, polypropylene, polystyrene, polyimide, polyvinyl alcohol, polyvinyl chloride, fluorine-containing resins such as polyfluoroethylene, nylon and cellulose.

The thickness of the base film 14 is not particularly limited, but is preferably about 25 to 100 µm.

The surface of the base film 14 may be subjected to release treatment. The procedure of releasing the base film can thereby easily conducted in the step of transferring the laminate sheet to a glass substrate.

The method of applying the paste composition as a material forming the glass resin composition layer onto a base film includes, for example, coating methods with roll coaters such as gravure coater, kiss-roll and comma, die coaters such as slot and fountain, squeeze coaters and curtain coaters may be used, but any methods capable of forming a uniform coating on a base film can be used.

The thickness of the glass resin composition layer is varied depending on the content of inorganic powder, the type and size of panel, and the size of a discharge space (height of the rib), but is preferably 50 to 400 µm, more preferably 80 to 300 µm.

The surface of the viscoelastic layer 13 may be provided with a protective film 15. The material forming the protective film includes, for example, polyethylene terephthalate, polyester, polyethylene, polypropylene etc. The laminate sheet covered with the protective film can be stored and supplied in a rolled state. The surface of the protective film may be subjected to release treatment.

The thickness of the protective film 15 is not particularly limited, but is preferably about 25 to 100 µm.

As a method of applying the barrier layer-forming composition or the viscoelastic layer-forming composition onto each layer, a release liner or a protective film, the coating method described above can be used, but any methods can be used insofar as a uniform coating can be formed.

The thickness (dry film thickness) of the barrier layer 12 is determined suitably depending on the thickness of the dielectric layer-forming film required for coverage of electrodes, and is preferably 0.1 to 30 µm, more preferably 0.5 to 20 µm, still more preferably 1 to 15 µm. When the thickness of the barrier layer is less than 0.1 µm, the barrier layer does not have sufficient viscoelasticity, and thus the glass resin composition layer and the viscoelastic layer may be cut considerably in sand blast treatment so that the thickness of the dielectric layer for coverage of electrodes is made insufficient, to fail to secure desired dielectric characteristics.

On the other hand, when the thickness of the barrier layer is greater than 30 µm, organic components remain on the glass substrate after baking, and the qualities of the back substrate for PDP tend to be lowered. The viscoelasticity of the barrier layer becomes so significant that the glass resin composition layer tends to be hardly cut in sand blast treatment. Accordingly, it is made difficult to form ribs of high height (to secure a sufficient discharge space), and the efficiency of cutting of the glass resin composition layer tends to be worsened.

The thickness of the viscoelastic layer 13 (dry film thickness) is determined suitably depending on retention (adhesiveness) required to retain the glass resin composition layer on the glass substrate having electrodes or an electrode pattern, the thickness of the dielectric layer-forming film required to cover electrodes or an electrode pattern, and the thickness of a dielectric layer formed by baking the viscoelastic layer, but is preferably 5 to 100 µm, more preferably 10 to 50 µm. When the thickness of the viscoelastic layer is less than 5 µm, the total thickness of the dielectric layer covering electrodes may be insufficient, thus failing to secure desired dielectric characteristics. On the other hand, when the thickness of the viscoelastic layer is greater than 100 µm, organic components remain on the glass substrate after baking, and the qualities of the back substrate for PDP tend to be lowered. Further, the strength of the viscoelastic layer is lowered so that upon attachment of the laminate sheet to the glass substrate, the attachment position tends to be easily deviated from the right position. Further, the viscoelasticity of the viscoelastic layer is increased so that when the viscoelasticity of the barrier layer is sufficiently high, the glass resin composition layer may, owing to their synergistic effect, be hardly cut in sand blast treatment. Accordingly, it is made difficult to form ribs of high height (to secure a sufficient discharge space), and the efficiency of cutting of the glass resin composition layer tends to be worsened.

In the laminate sheet of the present invention, a photoresist layer 16 may be laminated between the glass resin composition layer 11 and the base film 14. Using the photoresist layer, a resist pattern not cut by sand blast treatment is formed on the glass resin composition layer by photolithography. The photoresist layer 16 can be formed by coating and drying a photosensitive resin-containing paste composition on the base film 14 or the glass resin composition layer 11, or by attaching a sheet-shaped dry film made of a photosensitive resin thereto.

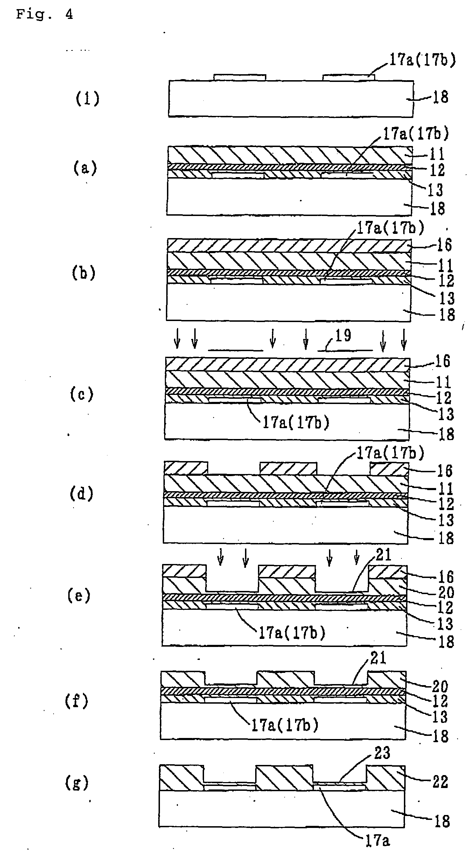

Hereinafter, the method of producing a back substrate for PDP by using the laminate sheet is described. Fig. 4 shows one example of the method of producing a back substrate for PDP according to the present invention.

Fig. 4 (1) is a sectional view showing the structure of a glass substrate with electrodes, which has an electrode 17a or an electrode pattern 17b formed on a glass substrate 18. The method of forming the electrode pattern 17b on the glass substrate 18 is not particularly limited, and a known method can be used. For example, mention is made of a method of forming an electrode pattern by applying a metal paste that is an electrode-forming material onto a glass substrate by screen printing, a method of forming an electrode pattern by photolithography of a metal paste applied onto a glass substrate by a known coating method, etc. In the metal paste, conventionally used materials can be used without particular limitation, and mention is made of a mixture of an electrode-constituting metal, an organic binder, an organic solvent, low-melting glass powder, etc. The metal includes, for example, silver, copper, aluminum, chromium etc. The organic binder includes, for example, (meth)acrylic resin, vinyl resin, cellulose resin etc.

The method of forming the electrode 17a on the glass substrate 18 is not particularly limited, and a known method can be used. Mention is made of, for example, a method that involves forming an electrode pattern on a glass substrate by the method described above and then baking the electrode pattern to form an electrode, a method that involves forming a metallic film by a film-making method such as CVD or sputtering and subsequent patterning to form an electrode by an etching method or a lift-off method, etc.

Step (a) is a step of attaching the viscoelastic layer 13 of the laminate sheet onto the glass substrate 18 having the electrode 17a or electrode pattern 17b. In the case of transmission PDP, the electrode serves as a display electrode, and in the case of reflective PDP, the electrode serves as an address electrode. When the laminate sheet has a protective film, the viscoelastic layer is attached after release of the protective film. When the laminate sheet has a base film after attachment of the viscoelastic layer, the laminate sheet is transferred after release of the base film. The transfer conditions are for example as follows: the laminator surface temperature is 25 to 100°C, the roll linear pressure is 0.5 to 15 kg/cm and the transfer speed is 0.1 to 5 m/min., but these conditions are not intended to be limitative. The glass substrate may be preheated, and the preheat temperature is about 50 to 150°C.

Steps (b) to (d) are pattern-forming steps of forming a resist pattern on the surface of the glass resin composition layer 11. Step (b) is a step of laminating a photoresist layer 16 on the surface of the glass resin composition layer 11. The photoresist layer can be formed by applying a photosensitive resin-containing paste composition onto the surface of the glass resin composition layer and drying the resulting coating or by attaching a dry film resist thereto. However, when a laminate sheet having a photoresist layer laminated on the glass resin composition layer is used, step (b) is not necessary. The photoresist layer may be positive or negative. In the positive photoresist layer, a region exposed to light is removed by development. In the negative photoresist layer, a region not exposed to light is removed by development. The method of producing a back substrate for PDP as shown in Fig. 4 is illustrated by using a negative photoresist. A photoresist developable with water or an aqueous alkali solution is preferably used in order that the glass resin composition layer is not adversely affected at the time of resist development.

Step (c) is a step wherein a pattern-forming mask 19 is stacked on the photoresist layer 16, and the photoresist layer 16 is exposed to light via the pattern-forming mask 19.

Step (d) is a step wherein the photoresist layer 16 is developed to form a resist pattern. By development, the region not exposed to light is removed, and the region exposed to light remains. By the steps (b) to (d), a resist pattern can be formed on the surface of the glass resin composition layer, but direct patterning on the surface of the glass resin composition layer by screen printing is also feasible, and in this case, steps (b) to (d) are not necessary. However, highly accurate patterning on a large area is conducted preferably by photolithography.

Step (e) is a sand blast step wherein the glass resin composition layer in openings of the resist pattern is subjected to sand blast treatment, whereby the rib-forming part 20 and the dielectric layer-forming film 21 covering electrodes or an electrode pattern are integrally formed. The sand blast treatment refers to a method of generally forming ribs, and specifically to a method wherein a resist pattern which cannot be cut by sandblasting is formed on a glass resin composition layer, and fine powder (abrasive) of alumina, glass beads and calcium carbonate is blown into the whole area of the glass resin composition layer, whereby the glass resin composition layer not covered with the resist pattern is cut to form a rib-forming part.

In the present invention, a barrier layer and a viscoelastic layer are arranged between the glass resin composition layer and the glass substrate having electrodes or an electrode pattern, and owing to the properties of the barrier layer and the viscoelastic layer, the rib-forming part and the dielectric layer-forming film covering electrodes or an electrode pattern can be integrally formed. In conventional production of a back substrate for PDP, electrodes on a glass substrate are covered first with a dielectric layer, and thereafter, ribs are formed on the dielectric layer, as described above. That is, formation of the dielectric layer and formation of the ribs are conducted separately, and thus the process is long and the efficiency of production is very low. According to the production method of the present invention, the rib-forming part and the dielectric layer-forming film covering electrodes or an electrode pattern can be formed simultaneously and integrally, and thus the production process can be significantly reduced to improve the efficiency of production. The reason that such significant effect is exhibited is not evident, but the following reason is conceivable.

That is, in the initial stage of sand blast treatment, the surface of the glass resin composition layer to be cut is hard, brittle and hardly elastic (free of cushioning properties), and thus the impact energy of an abrasive cannot be absorbed by the whole of the glass resin composition layer, and the impact energy is given concentrically to the area where the surface of the glass resin composition layer is contacted with the abrasive. It is therefore considered that in the initial stage of sand blast treatment, the glass resin composition layer is well cut. However, in sandblasting near to the final stage of sand blast treatment, the impact energy of the abrasive is dissipated owing to the influence of the barrier layer having elasticity (cushioning properties) and the viscoelastic layer under the thinned glass resin composition layer, and the impact energy of the area where the surface of the glass resin composition layer is contacted with the abrasive is relaxed. It is therefore considered that the glass resin composition layer is hardly cut, and a thin film serving as the dielectric layer-forming film is formed.

The jet pressure of the abrasive in the sand blast treatment is not particularly limited, but is preferably 0.02 to 0.2 MPa, more preferably 0.04 to 0.15 MPa, from the viewpoint of the efficiency of cutting and the formation of the rib-forming part of high accuracy and the dielectric layer-forming film of suitable thickness.

The height of the rib-forming part 20 is not particularly limited, but is usually 50 to 400 µm, preferably 80 to 300 µm. The line width on the top of the rib-forming part is not particularly limited either, but is usually 30 to 100 µm, preferably 30 to 70 µm.

The thickness of the dielectric layer-forming film 21 covering electrodes is not particularly limited, but is preferably 0.1 to 30 µm, more preferably 0.1 to 20 µm in consideration of the thickness of the dielectric layer after baking.

Step (f) is a step of removing the resist pattern on the glass resin composition layer. The method of removing the resist pattern is not particularly limited, and a known method can be used. For example, a method of releasing it with a release solution or a method of peeling it off can be mentioned. In the present invention, the resist pattern may be removed by pyrolysis upon baking the rib-forming part and the dielectric layer-forming film, but is preferably removed before the baking step.

Step (g) is a step wherein the rib-forming part 20 and the dielectric layer-forming film 21 formed by the method described above are baked to form a rib 22 and a dielectric layer 21 integrally. The viscoelastic layer 13 is also baked in the baking step to form the dielectric layer 23. The barrier layer is removed by pyrolysis in the baking step. When the barrier layer contains a small amount of inorganic powder, it is baked in the baking step to serve as a part of the dielectric layer.

When the electrode pattern 17b is formed on the glass substrate, the electrode pattern 17b upon baking the rib-forming part 20, the dielectric layer-forming film 21, the barrier layer 12 and the viscoelastic layer 13 is also baked to form an electrode 17a. The production method of the present invention is extremely superior in production efficiency because the electrode, the rib and the dielectric layer can be formed in the baking step conducted only once.

The method of baking is not particularly limited insofar as the rib and the dielectric layer covering electrodes can be integrally formed, and a known method can be used. For example, the glass substrate having a rib-forming part, a dielectric layer-forming film, a barrier layer, a viscoelastic layer and electrodes or an electrode pattern, formed by the method described above, is arranged in an atmosphere of 200 to 450°C, preferably 300 to 420°C, whereby organic materials (resin component, residual solvent, various kinds of additives etc.) in the rib-forming part, the dielectric layer-forming film, the electrode pattern, the barrier layer and the viscoelastic layer, and a resist for resist pattern if any, are removed by pyrolysis. Thereafter, inorganic powders in the rib-forming part, the dielectric layer-forming film, (barrier layer), and the viscoelastic layer are melted and baked at 450 to 600°C, preferably 540 to 585°C. When the electrode pattern contains inorganic powder such as low-melting glass powder, the inorganic powder is simultaneously melted and baked. On the glass substrate having electrodes, the rib consisting of the inorganic baked material, and the dielectric layer, are thereby integrally formed in the same step. The inorganic powders in the barrier layer and the viscoelastic layer are fused by melting to the inorganic powder in the dielectric layer-forming film, and together with the inorganic powder in the dielectric layer-forming film, form a dielectric layer.

Even if the dielectric layer obtained by baking the dielectric layer-forming film in the present invention is very thin, the electrodes on the glass substrate can be covered sufficiently with the dielectric layer obtained by baking the inorganic powder-containing viscoelastic layer.

The total thickness of the dielectric layer covering electrodes after baking is not particularly limited, but is preferably 1 to 30 µm, more preferably 5 to 20 µm. When the total thickness of the dielectric layer covering electrodes is less than 1 µm, desired dielectric characteristics may not be achieved. On the other hand, when the total thickness is greater than 30 µm, brightness tends to be lowered due to a reduction in the discharge space.

The height of the rib after baking is not particularly limited, but is usually 50 to 300 µm, preferably 80 to 200 µm.

The back substrate for PDP in the present invention is thereafter produced by forming e.g. a fluorescent layer on the ribs and the dielectric layer. The method of producing the back substrate for PDP can be applied to production of every kind of back substrate for PDP having ribs and a dielectric layer arranged thereon.

Further, the back substrate for PDP can be used preferably as alternating current PDP of surface discharge type or counter discharge type.

### EXAMPLES

Hereinafter, the present invention is described in more detail by reference to the Examples, but the present invention is not limited thereto.

### Example 1

### [Formation of a glass resin composition layer]

100 parts by weight of glass frit (RFW-401C manufactured by Asahi Glass Company), 2.5 parts by weight of polyvinyl butyral (Denka Butyral 3000-V manufactured by Denki Kagaku Kogyo Kabushiki Kaisha) and 0.3 parts by weight of trioctyl trimellitate (TOTM) as plasticizer were added to 35 parts by weight of a solvent (mixed solvent of α-terpineol/n-butyl acetate carbitol = 9/1 (ratio by weight)), and dispersed preliminarily with a disper (rotating propeller stirring machine) and then dispersed with a 3-roll dispersing machine to prepare a uniformly mixed glass paste composition. The glass paste composition thus prepared was applied by a roll coater onto a base film consisting of a polyethylene terephthalate (PET) film treated with a release agent, and the coating was dried at 140°C for 5 minutes to remove the solvent, whereby a glass resin composition layer (thickness: 160 µm) was formed.

### [Formation of a barrier layer]

40 parts by weight of an acrylic polymer (A) having a weight-average molecular weight of 500,000, consisting of butyl acrylate/acrylic acid (monomer ratio by weight: 100/5), 0.05 parts by weight of an epoxy crosslinking agent (TETRAD C manufactured by Mitsubishi Gas Chemical Company, Inc.) and 60 parts by weight of toluene were mixed to prepare a barrier layer-forming composition. A release liner consisting of a polyethylene terephthalate (PET) film treated with a release agent was coated by a roll coater with the barrier layer-forming composition prepared above, and the coating was dried and cured at 80°C for 3 minutes to remove the solvent, whereby a barrier layer (thickness: 10 µm) was formed thereon to give a barrier layer transfer sheet. The barrier layer of the barrier layer transfer sheet was stacked on the glass resin composition layer and contact-bonded by a roll laminator to transfer the barrier layer onto the glass resin composition layer to give a 3-layer structure sheet.

### [Formation of a viscoelastic layer]

In a four-necked flask equipped with a stirring blade, a thermometer, a nitrogen gas inlet tube, a condenser and a dropping funnel, 99 parts by weight of 2-ethylhexyl methacrylate, 1 part by weight of hydroxypropyl methacrylate (Light Ester HOP manufactured by Kyoeisha Chemical Co., Ltd.) and a polymerization initiator were added to toluene, and while the temperature of the solution in the flask was maintained at 75°C, polymerization reaction was conducted for about 8 hours under gentle stirring in a nitrogen gas, to prepare methacrylic polymer (B). The weight-average molecular weight of the resulting methacrylic polymer (B) was about 100,000.

100 parts by weight of glass frit (RFW-401C manufactured by Asahi Glass Company), 16 parts by weight of the methacrylic polymer (B), 40 parts by weight of α-terpineol as solvent and 3 parts by weight of trioctyl trimellitate as plasticizer were mixed by a dispersing machine to prepare a viscoelastic layer resin composition.

A protective film (release liner) consisting of a polyethylene terephthalate (PET) film treated with a release agent was coated by a roll coater with the viscoelastic layer resin composition prepared above, and the coating was dried at 150°C for 5 minutes to remove the solvent, whereby a viscoelastic layer (thickness: 20 µm) was formed thereon to give a 2-layer structure sheet.

### [Formation of a laminate sheet]

The barrier layer of the 3-layer structure sheet and the viscoelastic layer of the 2-layer structure sheet were stacked and contact-bonded by a roll laminator to prepare a laminate sheet consisting of a base film, a glass resin composition layer, a barrier layer, a viscoelastic layer and a protective film.

### [Formation of a back substrate for PDP]

The laminate sheet was cut in a predetermined size, and the protective film was released. Then, the viscoelastic layer of the laminate sheet was stacked on a glass substrate (PD200 manufactured by Asahi Glass Company) having electrodes, and then contact-bonded by a roll laminator. Thereafter, the base film was released thereby transferring the laminate sheet consisting of a glass resin composition layer, a barrier layer and a viscoelastic layer to prepare a glass substrate provided with the laminate sheet.

Then, a dry film resist (Ordeal series manufactured by Tokyo Ohka Kogyo Co., Ltd.) was laminated as a photoresist layer by a heated roll on the glass resin composition layer of the glass substrate provided with the laminate sheet. Then, a pattern-forming mask having a line width of 50 µm and a pitch of 300 µm was registered and laminated on the glass resin composition layer, and the photoresist layer was exposed to UV rays via the pattern-forming mask.

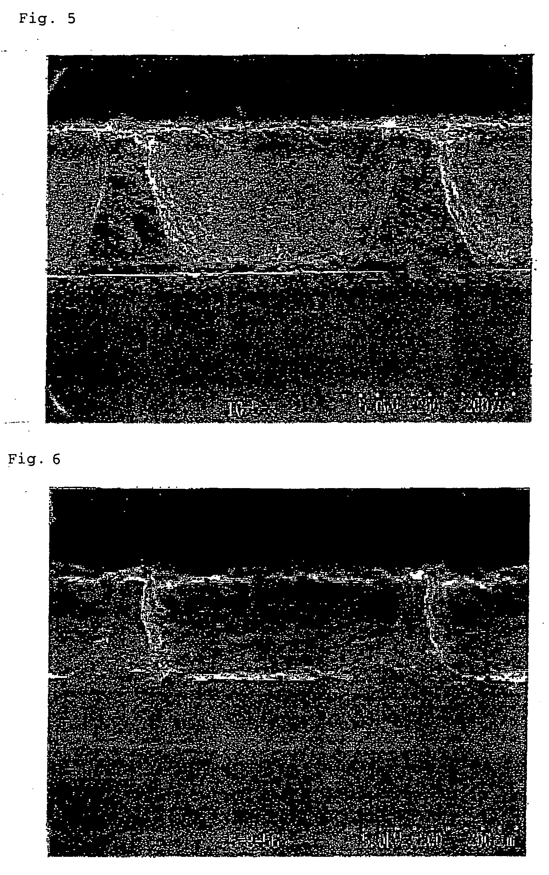

After exposure to light, the glass resin composition layer was developed with a developing solution of sodium carbonate to remove the resist on the region not exposed to light. Then, the glass resin composition layer in openings of the resist pattern was subjected to sand blast treatment (abrasive, calcium carbonate particle #800; jet pressure, 0.06 MPa) to form the rib-forming part and the dielectric layer-forming film (thickness, about 5 µm) integrally. Thereafter, the resist on the glass resin composition layer was released by peeling from the edge. The line width on the top of the rib-forming part was about 50 µm, and the height was about 160 µm. Fig. 5 is a microphotograph (SEM photograph, x200) of a section of the glass substrate having the rib-forming part and the dielectric layer-forming film formed integrally thereon. As can be seen from this photograph, the rib-forming part and the dielectric layer-forming film are formed integrally on the barrier layer, and the viscoelastic layer is protected by the barrier layer and is thus not influenced by sand blast treatment.

Then, the glass substrate having the rib-forming part and the dielectric layer-forming film formed thereon was placed in a baking furnace and baked at a furnace temperature of 400°C for 30 minutes, whereby organic materials (resin component, residual solvent, various kinds of additives etc.) in the rib-forming part, the dielectric layer-forming film and the viscoelastic layer, and the barrier layer, were removed by pyrolysis. Thereafter, it was baked at 560°C for 30 minutes to melt and bake the glass frit in the rib-forming part, the dielectric layer-forming film and the viscoelastic layer. As a result, the ribs (line width on the top, about 35 µm; height, about 110 µm) and the electrode-covering dielectric layer (thickness, about 10 µm) had been integrally formed on the glass substrate. Fig. 6 is a microphotograph (SEM photograph, ×200) of a section of the glass substrate having the ribs and the dielectric layer formed integrally thereon. As can be seen from this photograph, the ribs and the dielectric layer are formed integrally on the glass substrate. It can also be seen that the barrier layer was completely eliminated by pyrolysis.

### Example 2

### [Formation of an electrode pattern]

An electrode-forming silver paste (Foudel DC series manufactured by DuPont) was applied by screen printing onto a glass substrate for PDP (PD200 manufactured by Asahi Glass Company) and then dried to form an electrode pattern (not baked) having a height of 5 µm, a line width of 30 µm and a pitch of 300 µm.

### [Formation of a laminate sheet]

A laminate sheet was prepared by the same method as in Example 1.

### [Formation of a back substrate for PDP]

The laminate sheet was cut in a predetermined size, and the protective film was released. Then, the viscoelastic layer of the laminate sheet was stacked on the glass substrate having an electrode pattern, and then contact-bonded by a roll laminator. Thereafter, the base film was released thereby transferring the laminate sheet consisting of a glass resin composition layer, a barrier layer and a viscoelastic layer to prepare a glass substrate provided with the laminate sheet.

Then, a dry film resist (Ordeal series manufactured by Tokyo Ohka Kogyo Co., Ltd.) was laminated as a photoresist layer by a heated roll on the glass resin composition layer of the glass substrate provided with the laminate sheet. Then, a pattern-forming mask having a line width of 50 µm and a pitch of 300 µm was registered and laminated on the glass resin composition layer, and the photoresist layer was exposed to UV rays via the pattern-forming mask.

After exposure to light, the glass resin composition layer was developed with a developing solution of sodium carbonate to remove the resist on the region not exposed to light. Then, the glass resin composition layer in openings of the resist pattern was subjected to sand blast treatment (abrasive, calcium carbonate particle #800; jet pressure, 0.06 MPa) to form the rib-forming part and the dielectric layer-forming film (thickness, about 5 µm) integrally. Thereafter, the resist on the glass resin composition layer was released by peeling from the edge. The line width on the top of the rib-forming part was about 50 µm, and the height was about 160 µm. When its section was observed with a microscope, the rib-forming part and the dielectric layer-forming film had been integrally formed on the barrier layer.

Then, the glass substrate having the rib-forming part and the dielectric layer-forming film formed thereon was placed in a baking furnace and baked at a furnace temperature of 400°C for 30 minutes, whereby organic materials (resin component, residual solvent, various kinds of additives etc.) in the rib-forming part, the dielectric layer-forming film, the viscoelastic layer and the electrode pattern, and the barrier layer, were removed by pyrolysis. Thereafter, it was baked at 560°C for 30 minutes to melt and bake the glass frit in the rib-forming part, the dielectric layer-forming film and the viscoelastic layer, and the electrode pattern. When its section was observed with a microscope, the rib (line width on the top, about 35 µm; height, about 110 µm) and the electrode-covering dielectric layer (thickness, about 10 µm) had been integrally formed on the glass substrate. The barrier layer had been completely eliminated by pyrolysis.

### Example 3

### [Formation of a glass resin composition layer]

By the same method as in Example 1, a glass resin composition layer (thickness: 160 µm) was formed on a release liner consisting of a PET film treated with a release agent, to give a glass resin composition layer provided with the release liner.

### [Formation of a barrier layer]

A barrier layer (thickness: 10 µm) was formed by the same manner as in Example I on a release liner consisting of a PET film treated with a release agent, to give a barrier layer provided with the release liner. The release liner was released from the glass resin composition layer provided with the release liner, and the barrier layer of the barrier layer provided with the release liner was stacked on the release surface of the glass resin composition layer. Further, a PET base film was stacked on the other side of the glass resin composition layer. Thereafter, they were contact-bonded by a roll laminator to prepare a 4-layer structure sheet consisting of the base film, the glass resin composition layer, the barrier layer, and the release liner.

### [Formation of a viscoelastic layer]

A viscoelastic layer (thickness: 20 µm) was formed in the same manner as in Example 1 on a protective film consisting of a PET film treated with a release agent, to give a viscoelastic layer provided with the protective film.

### [Formation of a laminate sheet]

The release liner was released from the 4-layer structure sheet. The viscoelastic layer of the viscoelastic layer provided with the protective film was stacked on the barrier layer appearing by release. Thereafter, they were contact-bonded by a roll laminator to prepare a laminate sheet consisting of the base film, the glass resin composition layer, the barrier layer, the viscoelastic layer and the protective film.

### [Preparation of a back substrate for PDP]

A back substrate for PDP was prepared by the same method as in Example 1. As a result, the rib (line width on the top, about 35 µm; height, about 110 µm) and the electrode-covering dielectric layer (thickness, about 10 µm) had been integrally formed on the glass substrate. The barrier layer had been completely eliminated by pyrolysis.

### Example 4

### [Formation of a glass resin composition layer]

A glass resin composition layer (thickness: 160 µm) was formed in the same manner as in Example 1 on a release liner consisting of a PET film treated with a release agent, to give a glass resin composition layer provided with the release liner.

### [Formation of a barrier layer]

100 parts by weight of an acrylic polymer (C) having a weight-average molecular weight of 300,000, consisting of 2-ethylhexyl acrylate/ethyl acrylate/methyl methacrylate/2-hydroxyethyl acrylate (monomer ratio by weight: 28/66/5/1), 5 parts by weight of glass frit (RFW-401C manufactured by Asahi Glass Company), 0.05 part by weight of an epoxy crosslinking agent (TETRAD C manufactured by Mitsubishi Gas Chemical Company, Inc.) and 100 parts by weight of toluene were mixed to prepare a barrier layer-forming composition. A release liner consisting of a polyethylene terephthalate (PET) film treated with a release agent was coated by a roll coater with the barrier layer-forming composition prepared above, and the coating was dried and cured at 80°C for 3 minutes to remove the solvent, whereby a barrier layer (thickness, 10 µm; glass frit content, 4.8 wt%) was formed thereon to give a barrier layer transfer sheet. The barrier layer of the rib transfer sheet was stacked on the glass resin composition layer and contact-bonded by a roll laminator to transfer the barrier layer onto the glass resin composition layer to give a 3-layer structure sheet.

### [Formation of a viscoelastic layer]

100 parts by weight of glass frit (RFW-401C manufactured by Asahi Glass Company), 16 parts by weight of the acrylic polymer (C), 40 parts by weight of α-terpineol as solvent and 3 parts by weight of trioctyl trimellitate as plasticizer were mixed by a dispersing machine to prepare a viscoelastic layer resin composition. A protective film (release liner) consisting of a polyethylene terephthalate (PET) film treated with a release agent was coated by a roll coater with the viscoelastic layer resin composition prepared above, and the coating was dried at 150°C for 5 minutes to remove the solvent, whereby a viscoelastic layer (thickness: 20 µm) was formed thereon to give a 2-layer structure sheet.

### [Formation of a laminate sheet]

The barrier layer of the 3-layer structure sheet and the viscoelastic layer of the 2-layer structure sheet were stacked and contact-bonded by a roll laminator to prepare a laminate sheet consisting of the base film, the glass resin composition layer, the barrier layer, the viscoelastic layer and the protective film.

### [Preparation of a back substrate for PDP]

A back substrate for PDP was prepared by the same method as in Example 1 except that in the step of removing organic substances by pyrolysis, the temperature in the furnace was 450°C, and the baking time was 20 minutes. As a result, the rib (line width on the top, about 35 µm; height, about 110 µm) and the electrode-covering dielectric layer (thickness, about 10 µm) had been integrally formed on the glass substrate. High-speed baking was conducted, and no release between the rib and the dielectric layer was observed, and cracking was not generated.

### INDUSTRIAL APPLICABILITY

The present invention relates to a laminate sheet used in integrally forming a dielectric layer and a rib, a method of producing a back substrate for plasma display panel by using the laminate sheet, a back substrate for plasma display panel, and a plasma display panel. By using the laminate sheet, the process of producing a back substrate for plasma display panel can be significantly reduced to improve the efficiency of production significantly.

## Claims

1. A laminate sheet used for integrally forming a dielectric layer and a rib on a glass substrate having electrodes, which comprises a barrier layer laminated on a glass resin composition layer containing inorganic powder and a binder resin, an inorganic powder-containing viscoelastic layer laminated on the barrier layer.

2. The laminate sheet according to claim 1, wherein a base film is laminated on the other side of the glass resin composition layer.

3. The laminate sheet according to claim 2, wherein a photoresist layer is laminated between the glass resin composition layer and the base film.

4. A method of producing a back substrate for plasma display panel, which comprises a step of attaching a viscoelastic layer of the laminate sheet of claim 1 onto a glass substrate having electrodes, a step of forming a resist pattern on the surface of the glass resin composition layer, a step of sandblasting the glass resin composition layer in openings of the resist pattern thereby integrally forming a rib-forming part and a dielectric layer-forming film covering electrodes, and a step of baking the rib-forming part, the dielectric layer-forming film, the barrier layer and the viscoelastic layer thereby forming the rib and the dielectric layer integrally.

5. A method of producing a back substrate for plasma display panel, which comprises a step of forming an electrode pattern consisting of a metal paste on a glass substrate, a step of attaching a viscoelastic layer of the laminate sheet of claim 1 onto the glass substrate having an electrode pattern, a step of forming a resist pattern on the surface of the glass resin composition layer, a step of sandblasting the glass resin composition layer in openings of the resist pattern thereby integrally forming a rib-forming part and a dielectric layer-forming film covering an electrode pattern, and a step of baking the electrode pattern, the rib-forming part, the dielectric layer-forming film, the barrier layer and the viscoelastic layer thereby forming electrodes and forming the rib and the dielectric layer integrally.

6. A method of producing a back substrate for plasma display panel, which comprises a step of attaching a viscoelastic layer of the laminate sheet of claim 2 or 3 onto a glass substrate having electrodes, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering electrodes, and a step of baking the rib-forming part, the dielectric layer-forming film, the barrier layer and the viscoelastic layer thereby forming the rib and the dielectric layer integrally.

7. A method of producing a back substrate for plasma display panel, which comprises a step of forming an electrode pattern consisting of a metal paste on a glass substrate, a step of attaching a viscoelastic layer of the laminate sheet of claim 2 or 3 onto the glass substrate having an electrode pattern, a step of releasing a base film from the laminate sheet, a step of forming a resist pattern on the surface of the glass resin composition layer, a step of sandblasting the glass resin composition layer in openings of the resist pattern thereby integrally forming a rib-forming part and a dielectric layer-forming film covering an electrode pattern, and a step of baking the electrode pattern, the rib-forming part, the dielectric layer-forming film, the barrier layer and the viscoelastic layer thereby forming electrodes and forming the rib and the dielectric layer integrally.

8. The method of producing a back substrate for plasma display panel according to any one of claims 4 to 7, wherein the pattern-forming step is a step of forming a resist pattern by laminating a photoresist layer and a pattern-forming mask on the glass resin composition layer and light-exposing and developing the photoresist layer via the pattern-forming mask.

9. The method of producing a back substrate for plasma display panel according to claim 6 or 7, wherein the pattern-forming step is a step of forming a resist pattern by laminating a pattern-forming mask on a photoresist layer and light-exposing and developing the photoresist layer via the pattern-forming mask.

10. The method of producing a back substrate for plasma display panel according to any one of claims 4 to 9, which comprises a step of removing the resist pattern on the glass resin composition layer between the sandblasting step and the baking step.

11. A back substrate for plasma display panel, which is produced by the method described in any one of claims 4 to 9.

12. A plasma display panel using the back substrate for plasma display panel described in claim 11.
